Europäisches Patentamt

European Patent Office

Office européen des brevets

(11) Publication number: **0 162 717 B1**

# EUROPEAN PATENT SPECIFICATION

(45) Date of publication of patent specification: **15.04.92** (51) Int. Cl.5: **G03F 1/08**

(21) Application number: **85303635.8**

(22) Date of filing: **23.05.85**

(54) **Method of forming mask pattern.**

(30) Priority: **23.05.84 JP 102496/84**

(43) Date of publication of application:
**27.11.85 Bulletin 85/48**

(45) Publication of the grant of the patent:
**15.04.92 Bulletin 92/16**

(84) Designated Contracting States:
**DE FR GB**

(56) References cited:
**GB-A- 2 048 786**

**THE BELL SYST. TECHN. JOURN., vol. 58, no.
5, May/June 1979, pages 1027-1036, The
American Telephone and Telegraph Co., US;
J.M. MORAN et al.: "High resolution, steep
profile, resist patterns"**

**PATENTS ABSTRACTS OF JAPAN, vol. 8, no.
36 (E-227)(1473), 16th February 1984; & JP-
A-58 196 022**

(73) Proprietor: **KABUSHIKI KAISHA TOSHIBA
72, Horikawa-cho Saiwai-ku
Kawasaki-shi Kanagawa-ken 210(JP)**

(72) Inventor: **Nakase, Makoto c/o Patent Division
Kabushiki Kaisha Toshiba 1-1 Shibaura
1-chome
Minato-ku Tokyo 105(JP)**
Inventor: **Okano, Haruo c/o Patent Division
Kabushiki Kaisha Toshiba 1-1 Shibaura
1-chome
Minato-ku Tokyo 105(JP)**

(74) Representative: **Freed, Arthur Woolf et al
MARKS & CLERK 57-60 Lincoln's Inn Fields
London WC2A 3LS(GB)**

EP 0 162 717 B1

## Description

The present invention relates to a method of forming a mask pattern used in the manufacture of a semiconductor device.

An etching mask is used in processing a semiconductor wafer. The surface of the wafer often has a stepped portion or an upheaved portion. If the surface having an upheaved portion is coated with a resist material, the resultant resist layer is rendered non-uniform in thickness, resulting in non-uniform size of the resist pattern formed after the light exposure and development. Specifically, that portion of the resist pattern which is positioned on the upheaved portion is made different in size from the other portion, giving rise to a problem in the fine processing of the wafer. Also, the exposing light is irregularly reflected from the side surface of the upheaved portion, giving rise to an error in the resist pattern.

A three layer resist method is known to the art as a measure for overcoming the problems described above. It is described for example in The Bell Syst. Techn. Journ., Vol 58, No. 5, May/June 1979, pages 1027 - 1036, for A.T.T; J.M. Moran et al., "High Resolution, Steep Profile, Resist Patterns". In this method, the wafer surface having an upheaved portion is coated with a photoresist material to form a thick, e.g. 2 $\mu$m thick, photoresist layer having a flat surface, followed by baking the photoresist layer. Then, the baked layer is covered with, for example, a $SiO_2$ layer having a thickness of about 100 nm. Further, an upper photoresist layer is formed on the $SiO_2$ layer, followed by forming a resist pattern on the $SiO_2$ layer by applying the ordinary resist patterning technique to the upper photoresist layer. The resist pattern thus formed is used in the subsequent step for selectively etching the $SiO_2$ layer so as to form a $SiO_2$ pattern. Finally, the thick lower photoresist layer is selectively etched by means of a reactive ion etching (RIE) using an oxygen gas, with the $SiO_2$ pattern used as a mask, so as to form a mask used for etching the wafer.

In the three-layer resist method outlined above, the photoresist layer on which the $SiO_2$ layer is formed has a flat surface, making it possible to straighten the resist pattern. Also, the thick lower resist layer is thinner in the portion above the upheaved portion of the wafer than in the other portion. However, since an anisotropic RIE is employed, an undercut is not generated along the side surface of the upheaved portion, with the result that it is possible to eliminate the difference in size between the region above the upheaved portion and the other region. Further, if the thick lower photoresist layer is made to have a sufficient light absorbing property, it is possible to prevent irregular reflection of light from the side surface of the upheaved portion. It follows that the three-layer resist method permits forming a highly accurate etching mask.

However, the three-layer resist method necessitates two additional etching steps, compared with the ordinary method, leading to a long processing time and an increased facility cost required for the additional etching steps.

To overcome the above-noted defect, a two-layer resist method is under development. Specifically, it is theoretically possible to employ a two-layer resist structure, if a layer corresponding to the $SiO_2$ layer included in the three-layer resist structure is sensitive to light and exhibits resistance to oxygen RIE. However, it is very difficult to find a material meeting the above-noted requirements. An inorganic resist such as Ag/Se-Ge is reported to be effective in the laboratory experiment. However, the inorganic resist mentioned contains heavy metals which may give bad influences to the semiconductor element, is not satisfactory in resolution and sensitivity, and involves complex processes. Thus, the two-layer resist method fails to solve the problem.

An object of the present invention is to provide a method of forming a mask pattern which makes it possible to form a mask pattern relatively easily and without fail even on the surface of a workpiece having an upheaved portion.

According to the present invention, there is provided a method of forming a mask pattern as defined in claim 1.

In order that the invention may be better understood, a prefered embodiment will now be described, by way of example only, with reference to the accompanying drawings, in which:

Figs. 1A to 1C are cross sectional views collectively showing a method of forming a mask pattern according to one embodiment of the present invention; and

Fig. 2 schematically shows a light-excited etching apparatus used for the mask pattern forming method of the present invention.

The present invention produces the most prominent effect when applied to the formation of a mask pattern on the surface of a workpiece having an upheaved portion. The following description covers the case where the surface of the workpiece has an upheaved portion.

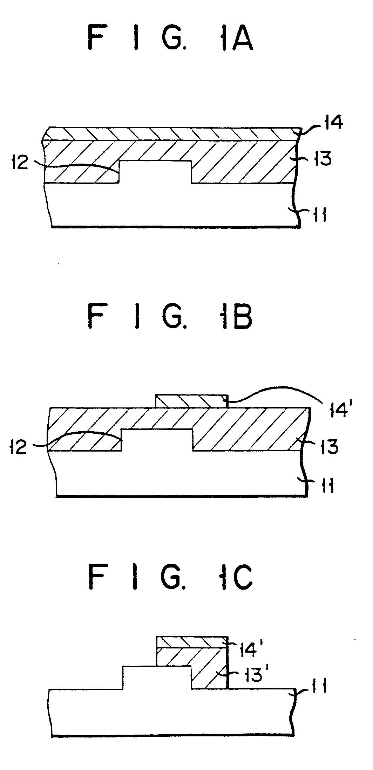

As shown in Fig. 1A, the entire surface of a silicon wafer 11 having an upheaved portion 12 is spin-coated first with an organic high molecular weight material, which has a flowability, so as to form a layer 13.

The organic material layer 13 should be thick enough, e.g., 2 μm thick, to provide a flat surface. The layer 13 is baked, as required, at, for example, 150°C for 30 minutes. It is possible to use an ordinary positive or negative photoresist (generally, a positive photoresist) as the organic high molecular material.

Then, an inorganic material layer 14 is formed on the organic material layer 13. Since the layer 13 has a flat surface, the inorganic material layer 14 also has a flat surface. The inorganic materials forming the layer 14 should be capable of providing a desired selective etching ratio with respect to the organic materials forming the layer 13, and include, for example, Si, Aℓ, W, Ta, Mo, alloys thereof, silicides thereof and oxides thereof. The inorganic material layer 14 can be formed by, for example, a sputtering technique in a thickness of 200 nm.

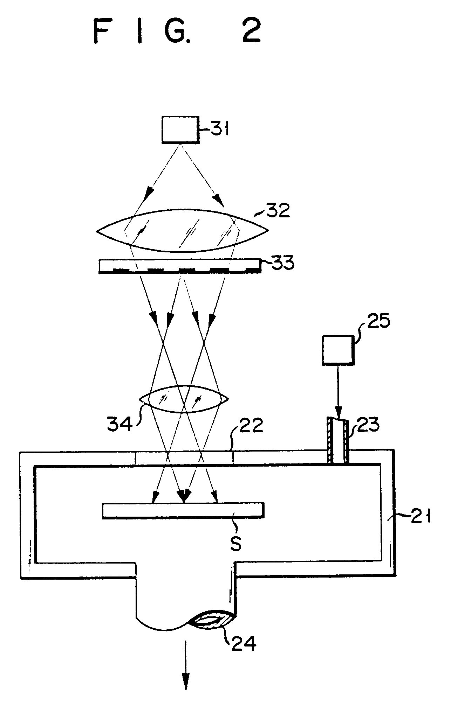

The inorganic material layer 14 thus formed is selectively etched in a light-excited etching apparatus shown in Fig. 2. A capital letter S shown in Fig. 2 denotes the structure shown in Fig. 1A. As seen from Fig. 2, the etching apparatus comprises a reaction chamber 21 housing the sample S. The chamber 21 is provided with a light transmitting window 22 formed in the upper wall to face the sample S, a reactive gas inlet port 23 and a gas outlet port 24. The inlet port 23 is connected to a reactive gas source 25.

A light exposure system is provided above the reaction chamber 21. As seen from the drawing, the exposure system comprises a light source 31, a projection lens 32, a photomask 33 corresponding to a prescribed mask pattern and an objective lens 34. The light emitted from the light source 31 passes through both the projection lens 32 and the mask 33. The light, which has passed through the mask 33 and, thus, carries the mask pattern information, further passes through the objective lens, with the result that the inorganic material layer 14 of the sample S is irradiated with the light carrying the mask pattern information.

For selectively etching the inorganic material layer 14 by using the light-excited etching apparatus shown in Fig. 2, the sample S is disposed within the reaction chamber 21, and a reactive gas is introduced from the reactive gas source 25 into the reaction chamber 21.

The reactive gas used in the present invention should be capable of reaction with the inorganic material of the layer 14 under the action of light or X-ray so as to form a volatile compound. The reactive gases meeting this requirement includes those containing at least one halogen atom. Specifically, the reactive gases used in the present invention include, for example, a halogen gas such as chlorine gas, bromine gas or iodine gas; a halogenated hydrocarbon such as tetrafluoromethane, trichloromethane, dichlorodifluoromethane and tetrachloromethane; as well as silicon tetrachloride and boron trichloride.

After introduction of the reactive gas into the reaction chamber 21, the reaction chamber 21 is evacuated through the gas outlet port 24 so as to adjust the pressure within the reaction chamber 21 at reduced pressures (e.g., 50 Torr) to the atmospheric pressure. Then, the surface of the inorganic material layer 14 is selectively irradiated with light having an absorption band with respect to the reactive gas, i.e., ultraviolet light, by utilizing the light exposure system provided above the reaction chamber 21.

Upon irradiation with light, the reactive gas is dissociated to form reactive species including radicals. On the other hand, the irradiated portion of the inorganic material layer 14 is excited. What should be noted is that chemical reactions take place between the reactive species and the excited inorganic material so as to form a volatile compound, e.g., a halide. The resultant volatile compound is evaporated within the reaction chamber 21. In this fashion, the inorganic material layer 14 is selectively etched.

Table 1 shows inorganic materials which can be used in the present invention, as well as the reactive gases, wavelengths of light, and the reactive gas pressures in the etching step, which are suitable for etching the inorganic materials.

Table 1

| Inorganic Material | Reactive Gas | Wavelength (nm) | Gas Pressure (Torr) |
|---|---|---|---|
| Si | Cℓ | 308 | 50 |
| Aℓ | CCℓ$_4$ | 308 | 50 |
| W | F$_2$ | 308 | 50 |
| Ta | F$_2$ | 308 | 50 |
| SiO$_2$ | NH$_3$ | 193 | 50 |

A mask pattern consisting of the remaining inorganic material layer 14' is formed by the selective etching of the inorganic material layer 14 described above, as seen from Fig. 1B. The mask pattern 14' is formed to cover the stepped portion of the wafer 11.

Finally, the organic high molecular weight material layer 13 is selectively etched with the mask pattern 14' used as the etching mask. It is most desirable to employ anisotropic RIE in this step. Generally, an oxygen gas is usually used as the reaction gas in this RIE treatment. Where, for example, a positive resist is used as the high molecular weight material, the oxygen gas pressure is set at 3 Torr, and the etching is performed for 30 minutes with a power of 150 W. As a result, a desired mask pattern consisting of the remaining organic material layer 13' is formed as shown in Fig. 1C.

As described above, a light-excited etching is employed in the present invention for selectively removing the uppermost layer, making it possible to accurately form a desired mask pattern even on the surface of a workpiece having an upheaved portion by utilizing a two-layer structure. Naturally, the mask pattern-forming process can be markedly simplified.

In the embodiment described above, an ultraviolet light is used in the step of selective etching of the inorganic material layer 14. However, an X-ray may be used in place of the ultraviolet light. Also, a photomask is provided apart from the surface of the sample in the embodiment described above. However, it is also possible to provide the photomask in direct contact with the sample.

## Claims

1. A method of forming a mask pattern, comprising the steps of:

   forming a first film (13) comprising an organic high molecular weight material and having a flat surface on a workpiece (11);

   forming a second film (14) comprising an inorganic material on the flat surface of the first film, said second film being capable of permitting a selective etching with respect to the first film;

   etching the second film selectively;

   and selectively etching the first film with the remainder of the second film (14') used as a mask, thereby to form a mask pattern (13', 14') comprising the remainder of the first film;

   characterised in that the second film (14) is etched by exposing the second film to a reactive gas atmosphere capable when irradiated of reaction with the second film to form a volatile compound;

   and selectively irradiating through a photomask (33) a selected region of the second film through the reactive gas atmosphere with an energy beam capable of dissociating directly the reactive gas, thereby to dissociate the reactive gas into reactive species and to allow the dissociated reactive species to selectively etch the irradiated region of the second film.

2. The method according to claim 1, characterized in that said reactive gas contains at least one halogen atom.

3. The method according to claim 2, characterized in that said reactive gas is selected from the group consisting of chlorine gas, bromine gas, iodine gas, tetrafluoromethane, trichloromethane, dichlorodifluoromethane, tetrachloromethane, silicon tetrachloride and boron trichloride.

4. The method according to claim 1, characterized in that said inorganic material is selected from the group consisting of silicon, aluminium, tungsten, tantalum, molybdenum, alloys thereof, silicides thereof and oxides thereof.

5. The method according to claim 1, characterized in that the pressure of said reactive gas atmosphere ranges reduced pressure to the atmospheric pressure.

6. The method according to claim 1, characterized in that said workpiece has an upheaved portion.

7. The method according to claim 1, characterized in that said energy beam comprises ultraviolet light or X-ray.

8. The method according to claim 1, characterized in that said first film is selectively etched by means of a reactive ion etching technique.

9. The method according to claim 8, characterized in that an oxygen gas is used in said reactive ion etching.

**Revendications**

1. Un procédé permettant d'obtenir un modèle de masque, comprenant les étapes suivantes:

    formation d'un premier film (13) comprenant un matériau organique à poids moléculaire élevé et comportant une surface plate sur une pièce à usiner (11);

    formation d'un deuxième film (14) comprenant un matériau inorganique sur la surface plate du premier film, ledit deuxième film étant capable de permettre une gravure sélective par rapport au premier film;

    gravure sélective du deuxième film; et

    gravure sélective du premier film avec le restant du deuxième film (14') utilisé comme masque, pour former ainsi un modèle de masque (13', 14') comprenant le restant du premier film;

    caractérisé en ce que le deuxième film (14) est gravé par exposition du deuxième film à une atmosphère de gaz réactif, capable, en cas d'irradiation, d'entrer en réaction avec le deuxième film pour former un composé volatile;

    et par une irradiation sélective par l'intermédiaire d'un photomasque (33) d'une région sélectionnée du deuxième film, par exposition à travers l'atmosphère de gaz réactif, avec un faisceau énergétique capable de dissocier directement le gaz réactif, pour dissocier ainsi le gaz réactif en espèces réactives et pour permettre aux espèces réactives dissociées de graver sélectivement la région irradiée du deuxième film.

2. Le procédé selon la revendication 1, caractérisé en ce que ledit gaz réactif contient au moins un atome d'halogène.

3. Le procédé selon la revendication 2, caractérisé en ce que ledit gaz réactif est choisi dans le groupe constitué de gaz de chlore, de gaz de brome, de gaz d'iode, de tétrafluorométhane, de trichlorométhane, de dichlorodifluorométhane, de tétrachlorométhane, de tétrachlorure de silicium et de trichlorure de bore.

4. Le procédé selon la revendication 1, caractérisé en ce que ledit matériau inorganique est choisi dans le groupe constitué de silicium, d'aluminium, de tungstène, de tantalum, de molybdène ainsi que d'alliages, de siliciures et d'oxydes correspondants.

5. Le procédé selon la revendication 1, caractérisé en ce que la pression de ladite atmosphère de gaz réactif est comprise dans un intervalle de pressions réduites par rapport à la pression atmosphérique.

6. Le procédé selon la revendication 1, caractérisé en ce que ladite pièce à usiner comporte une partie relevée.

7. Le procédé selon la revendication 1, caractérisé en ce que ledit faisceau énergétique comprend de la lumière ultraviolette ou des rayons X.

8. Le procédé selon la revendication 1, caractérisé en ce que ledit premier film est gravé sélectivement au moyen d'une technique de gravure par rayonnement ionique réactif.

9. Le procédé selon la revendication 8, caractérisé en ce qu'un gaz d'oxygène est utilisé dans ladite gravure par rayonnement ionique réactif.

**Patentansprüche**

1. Verfahren zur Herstellung eines Maskenmusters durch: Ausbilden eines eine flache Oberfläche aufweisenden ersten Films (13), umfassend ein organisches hochmolekulares Material, auf einem Werkstück (11);

    Ausbilden eines zweiten Films (14), umfassend ein anorganisches Material, auf der flachen Oberfläche des ersten Films, wobei der zweite Film die Fähigkeit besitzt, eine in bezug auf den ersten Film selektive Ätzung zuzulassen;

    selektives Ätzen des zweiten Films und

5

selektives Ätzen des ersten Films, wobei der Rest des zweiten Films (14') als Maske dient, zur Ausbildung eines den Rest des ersten Films umfassenden Maskenmusters (13', 14'),

**dadurch gekennzeichnet**, daß der zweite Film dadurch geätzt wird, daß er einer reaktiven Gasatmosphäre ausgesetzt wird, die bei Bestrahlung zur Reaktion mit dem zweiten Film unter Bildung einer flüchtigen Verbindung fähig ist, und
ein ausgewählter Bereich des zweiten Films durch die reaktive Gasatmosphäre hindurch selektiv mit einer zur direkten Dissoziation des reaktiven Gases fähigen Strahlungsenergie durch eine Photomaske (33) bestrahlt wird, um das reaktive Gas in reaktionsfähige Spezies zu dissoziieren und die dissoziierten reaktionsfähigen Spezies zur selektiven Ätzung des bestrahlten Bereichs des zweiten Films wirken zu lassen.

2. Verfahren nach Anspruch 1, dadurch gekennzeichnet, daß das reaktive Gas mindestens ein Halogenatom enthält.

3. Verfahren nach Anspruch 2, dadurch gekennzeichnet, daß das reaktive Gas aus der Gruppe Chlorgas, Bromgas, Jodgas, Tetrafluormethan, Trichlormethan, Dichlordifluormethan, Tetrachlormethan, Siliziumtetrachlorid und Bortrichlorid ausgewählt ist.

4. Verfahren nach Anspruch 1, dadurch gekennzeichnet, daß das anorganische Material aus der Gruppe Silizium, Aluminium, Wolfram, Tantal, Molybdän, Legierungen derselben, Siliciden derselben und Oxiden derselben ausgewählt wird.

5. Verfahren nach Anspruch 1, dadurch gekennzeichnet, daß der Druck der reaktiven Gasatmosphäre von Unterdruck bis Atmosphärendruck reicht.

6. Verfahren nach Anspruch 1, dadurch gekennzeichnet, daß das Werkstück einen erhabenen Bereich aufweist.

7. Verfahren nach Anspruch 1, dadurch gekennzeichnet, daß die Strahlungsenergie UV-Licht oder Röntgenstrahlung umfaßt.

8. Verfahren nach Anspruch 1, dadurch gekennzeichnet, daß der erste Film selektiv mittels reaktiver Ionenätzung geätzt wird.

9. Verfahren nach Anspruch 8, dadurch gekennzeichnet, daß bei der reaktiven Ionenätzung gasförmiger Sauerstoff verwendet wird.

# F I G. 1A

# F I G. 1B

# F I G. 1C

# F I G. 2